# EUROPEAN PATENT APPLICATION

(11) **EP 4 738 699 A1**
(43) Date of publication of application: **06.05.2026**
(21) Application number: 24306834.3
(22) Date of filing: 31.10.2024
(51) Int. Cl.: H03B 19/14

(54) **TRANSFORMER-BASED BIASING CIRCUIT FOR PUSH-PULL FREQUENCY DOUBLER**

(71) Applicant: NXP B.V., 5656 AG Eindhoven (NL)
(72) Inventor: FLETE, Alexander Vincent Nicolas, 31023 Toulouse (FR); LANCON, Leo Lucas, 31023 Toulouse (FR); PRUVOST, Sebastien, 38000 Grenoble (FR)
(74) Representative: Hardingham, Christopher Mark

(57) **Abstract**

A circuit includes a frequency doubler circuit including doubler core, an input matching network, and a cancellation network between the input matching network and the doubler core. The input matching network may include an input transformer including a primary inductor, a first secondary inductor including a first terminal coupled to a first gate and a second terminal coupled to a second gate of a first transistor pair of the doubler core, and a first center tap configured to receive a first bias voltage to bias the first and second gates. The input transformer may include a second secondary inductor including a first terminal coupled to the third gate and a second terminal coupled to the fourth gate of a second transistor pair of the doubler core, and a second center tap configured to receive a second bias voltage to bias the third and fourth gates of the second transistor pair.

## Description

### FIELD OF USE

The present disclosure generally relates to complementary metal-oxide semiconductor push-pull frequency doubler circuits, and more particularly to transformer-based biasing circuit for a push-pull frequency-doubler circuit core.

### BACKGROUND

High frequency signal generation in millimeter-wave systems can present challenges including high phase noise, narrow-band operation, signal loss associated with signal distribution, and so on.

### BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.
FIG. 1 depicts a circuit including a transformer-based biasing circuit configured to bias transistors of a complementary metal-oxide semiconductor (CMOS) frequency doubler core, in accordance with certain embodiments.
FIG. 2 depicts a graph of power gain versus the capacitance value on the center tap of the secondary inductors of the input transformer of FIG. 1 with and without capacitive common-mode cancellation, in accordance with certain embodiments.
FIG. 3 depicts an image of an embodiment of the layout of the circuit of FIG. 1 on a chip, in accordance with certain embodiments.
FIG. 4 depicts a flow diagram of a method of providing a frequency-doubled output using the circuit of FIG. 1, in accordance with certain embodiments.

While implementations are described in this disclosure by way of example, those skilled in the art will recognize that the implementations are not limited to the examples or figures described. Rather, the figures and detailed description thereto are not intended to limit implementations to the form disclosed, but instead the intention is to cover all modifications, equivalents, and alternatives falling within the spirit and scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

### DETAILED DESCRIPTION

A complementary metal-oxide semiconductor (CMOS) push-pull frequency doubler may include p-channel MOS field-effect transistors (PMOS) transistors and n-channel MOS field-effect transistors (NMOS) transistors configured to provide a push-pull circuit topology. The PMOS and NMOS transistors draw a relatively low current while using a relatively high voltage supply. The PMOS and NMOS transistors may need different bias voltages.

Embodiments of circuits and methods are described below that may include a push-pull core with an input matching network including a transformer having a primary inductor and two secondary inductors and a capacitive common-mode cancellation network. The secondary inductors may include center taps to which different bias voltages can be applied, which may bias the NMOS and PMOS gates without using biasing resistors or series capacitors. The circuit configuration may show an improvement of approximately one to two decibels voltage swing as compared to conventional push-pull frequency doubler circuits. The circuit configuration may provide more voltage swing, no biasing resistance, and improved phase noise. The circuit configuration may use the same circuit area as a conventional transformer. Additionally, the common-mode cancellation network may render the circuit insensitive to the impedance on the center taps that provide the gate-biasing voltages.

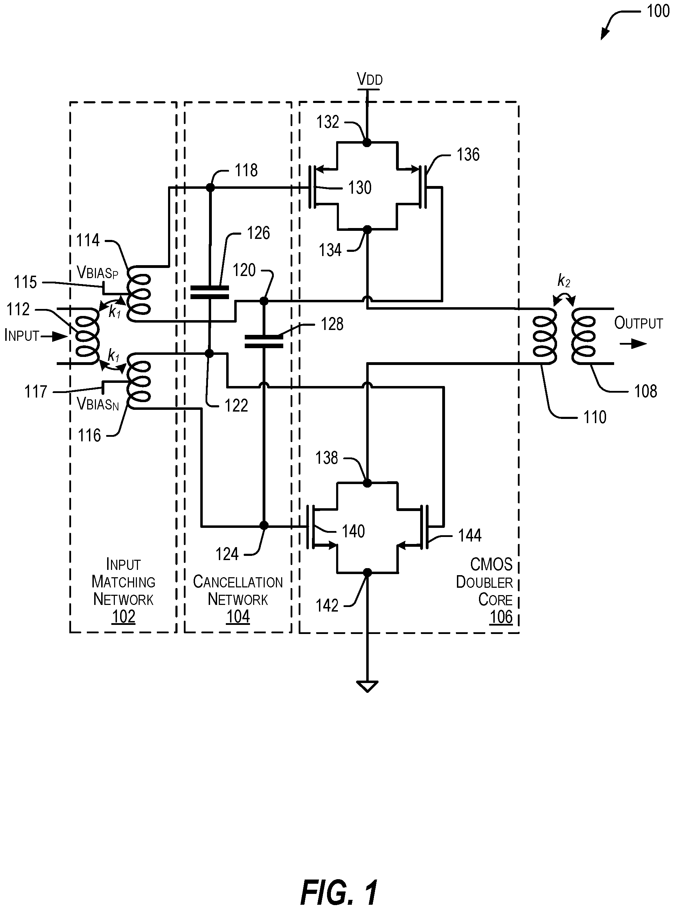

FIG. 1 depicts a circuit 100 including a transformer-based biasing circuit configured to bias transistors of a CMOS frequency doubler core, in accordance with certain embodiments. The circuit 100 may be an embodiment of a push-pull frequency doubler circuit. The circuit 100 may include an input matching network 102 configured to receive an input signal, a cancellation network 104 coupled to the input matching network 102, and a CMOS doubler core 106 coupled to the input matching network 102 via the cancellation network 104. The circuit 100 may include an output transformer including a primary inductor 110 coupled to the CMOS doubler core 106 and a secondary inductor 108 configured to provide the output signal, which may be at twice the frequency of the input signal at the input of the input matching network 102.

The input matching network 102 may include a transformer including a primary inductor 112 configured to receive the input signal and is inductively coupled to both secondary inductors 114 and 116 with the same coupling coefficient k1 to produce first and second transformer signals based on the input signal. In an alternative embodiment, the secondary inductors 114 and 116 may be inductively coupled to the primary inductor 112 by different coupling coefficients k. In one or more embodiments, there may be an inductive parasitic coupling (not shown) between the secondary inductors 114 and 116. The secondary inductor 114 may include a first terminal coupled to a node 118 and a second terminal coupled to a node 120. The secondary inductor 116 may include a first terminal coupled to a node 122 and a second terminal coupled to a node 124. The secondary inductor 114 may include a center tap 115 configured to receive a first bias voltage (VbiasP), which may bias gates of PMOS transistors 130 and 136 of the CMOS doubler core 106. The secondary inductor 116 may include a center tap 117 configured to receive a second bias voltage (VbiasN), which may bias gates of NMOS transistors 140 and 144. In one or more embodiments, the first bias voltage may be greater than the second bias voltage.

In one or more embodiments, depending on the threshold voltages Vtp of the PMOS transistors 130 and 136 as compared to the threshold voltages Vtn of the NMOS transistors 140 and 144, the bias voltage VbiasP at the center tap 115 may be different from the bias voltage VbiasN at the center tap 117. In one or more embodiment, the bias voltage at the center tap 115 may be less than the bias voltage at the center tap 117. In one or more embodiments, the bias voltage at the center tap 115 may be greater than the bias voltage at the center tap 117. In one or more embodiments, one or more of a first bias voltage at the center tap 115 or a second bias voltage at the center tap 117 may be adjusted to alter gate voltages of transistors of the CMOS doubler core 106.

The cancellation network 104 may be a capacitive common-mode cancellation network including a first capacitor 126 including a first terminal coupled to the node 118 and a second terminal coupled to the node 122. The cancellation network 104 may include a second capacitor 128 including a first terminal coupled to the node 120 and a second terminal coupled to the node 124.

The CMOS doubler core 106 may include PMOS transistors 130 and 136 and NMOS transistors 140 and 144. The PMOS transistor 130 may include a source coupled to a node 132, a gate coupled to the node 118, and a drain coupled to a node 134. The node 132 may be coupled to a supply voltage VDD. The PMOS transistor 136 may include a source coupled to the node 132, a gate coupled to the node 120, and a drain coupled to the node 134. The node 134 may be coupled to a first terminal of a primary inductor 110 of an output transformer, which may be inductively coupled to the secondary inductor 108 to provide the output signal. The transformer formed by the primary inductor 110 and the secondary inductor 108 may be inductively coupled with a coupling factor k2, which may be the same or different from the coupling factor kl.

The NMOS transistor 140 may include a drain coupled to a node 138, a gate coupled to the node 124, and a source coupled to a node 142. The NMOS transistor 144 may include a drain coupled to the node 138, a gate coupled to the node 122, and a source coupled to the node 142. The node 142 may be coupled to a second supply voltage, such as ground. The node 138 may be coupled to a second terminal of the primary inductor 110 of the output transformer. In one or more embodiments, a capacitor (not shown) may be coupled in parallel with the primary inductor 110 such that the capacitor may include a first terminal coupled to the node 134 and a second terminal coupled to the node 138.

In one or more embodiments, to avoid the performance degradation related to a resistor-capacitor (RC) bias network in the prior art, two secondary transformer inductors 114 and 116 are used as part of the input matching network 102. With two separated secondary inductors 114 and 116, bias voltages VbiasP and VbiasN may be applied to the PMOS transistors 130 and 136 and the NMOS transistors 140 and 144, respectively. The bias voltages may be different or the same. Since the center taps 115 and 117 of the secondary inductors 114 and 116 are considered as a common-mode net, biasing resistors are not required, and impedances on the center taps 115 and 117 do not affect the performances. In one or more embodiments, during operation, one or more of the bias voltages may be adjusted to alter the voltages at the gates of one or more of the transistors 130, 136, 140, or 144. The bias voltages may be adjusted independent of one another.

In this embodiment, an eighty gigahertz (80 GHz) output current can pass to the input through the transistor gate-to-drain capacitance (Cgd). This common-mode current may flow into both secondary inductors 114 and 116 of the input transformer, in the absence of the capacitive common-mode cancellation network 104. However, the cancellation network 104 may bypass the common-mode current.

In one or more embodiments, the circuit 100 includes a push-pull doubler core 106 including an output coupled to an output transformer (primary inductor 110 and secondary inductor 108) and including an input coupled to an input matching network 102 and a cancellation network 104. The input matching network 102 may include an input transformer including a primary inductor 112 and secondary inductors 114 and 116, and the input signal may transfer from the primary inductor 112 to the secondary inductors 114 and 116 with low losses. In one or more embodiments, the input transformer may include two or more secondary inductors, and the input signal may transfer to the two or more secondary inductors with low losses.

The secondary inductors 114 and 116 (and any additional secondary inductors) may include center taps 115 and 117 configured to receive direct current (DC) bias voltages, which are applied to the gates of the transistors 130, 136, 140, and 144 of the push-pull doubler core 106. The transformer center taps 115 and 117 may allow the bias voltages to be provided to the gates of the PMOS transistors 130 and 136 and the NMOS transistors 140 and 144 without degrading the noise performance. The capacitors 126 and 128 of the cancellation network 104 provide a well-controlled current path to overcome the gate-to-drain capacitances of the transistors 130, 136, 140, and 144.

In one or more embodiments, the circuit 100 may be employed in an automotive radar application. For example, the input matching network 102 and the cancellation network 104 may providing a biasing the CMOS doubler core 106 to provide a 40 GHz to 80 GHz frequency doubler for an automotive radar application. In one or more embodiments, the circuit 100 may allow for a reduction in an alternating current (AC) voltage in the matching network by approximately two decibels and an improvement in the two-megahertz (2 MHz) phase noise by about five decibels as compared to conventional doubler circuits. Saving two decibels of voltage swing with the input matching network 102 and the cancellation network 104 may provide a sixty percent decrease in DC power consumption under the same operating conditions in a previous driver stage. Additionally, the circuit 100 can be implemented within the same circuit area as conventional doubler circuits. The cancellation network 104 may provide capacitive common-mode cancellation, making the circuit insensitive to impedances on the center taps 115 and 117 of the secondary inductors 114 and 116, respectively.

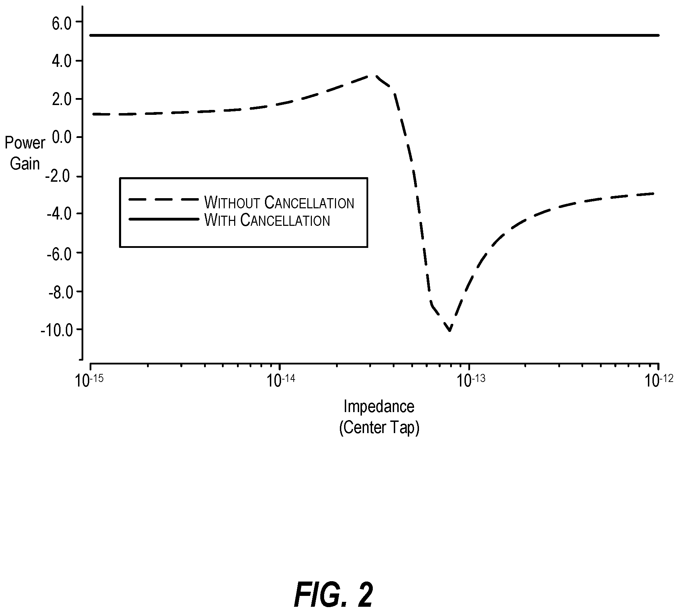

FIG. 2 depicts a graph 200 of power gain versus the capacitance value on the center tap of the secondary inductors of the input transformer for the circuit of FIG. 1 with and without capacitive common-mode cancellation, in accordance with certain embodiments. When using the transformer formed by the primary inductor 112 and the secondary inductors 114 and 116 for radio frequency (RF) matching, the design should be insensitive to impedance variation on the center taps 115 and 117 of the secondary inductors 114 and 116. As previously mentioned, the cancellation network 104 may make the circuit 100 insensitive to the impedances on the center taps 115 and 117.

In the graph 200, the gain of an embodiment of the circuit 100 is shown with and without the cancellation network 104. With respect to the graph of the circuit 100 without a cancellation network 104, the gain decreases when the center tap impedance is lower. In an example, the eighty gigahertz output current travels to the input through the gate-to-drain capacitance of the transistors 130, 136, 140, and 144. This common-mode current may then travel into both secondary inductors 114 and 116 of the input transformer, increasing the importance of the impedances on the center taps 115 and 117.

In one or more embodiments, the cancellation network 104 of the circuit 100 may be a capacitive common-mode cancellation network, which may render the circuit 100 relatively insensitive to the impedance on the center taps 115 and 117. As shown by the graph 200, the gain of the circuit 100 including the cancellation network 104 remains substantially unchanged when the center tap impedance changes. In operation, the common-mode current may flow into the capacitors instead of into the inductances on the center taps 115 and 117 of the secondary inductors 114 and 116, thereby rendering the circuit 100 insensitive to the center tap impedance.

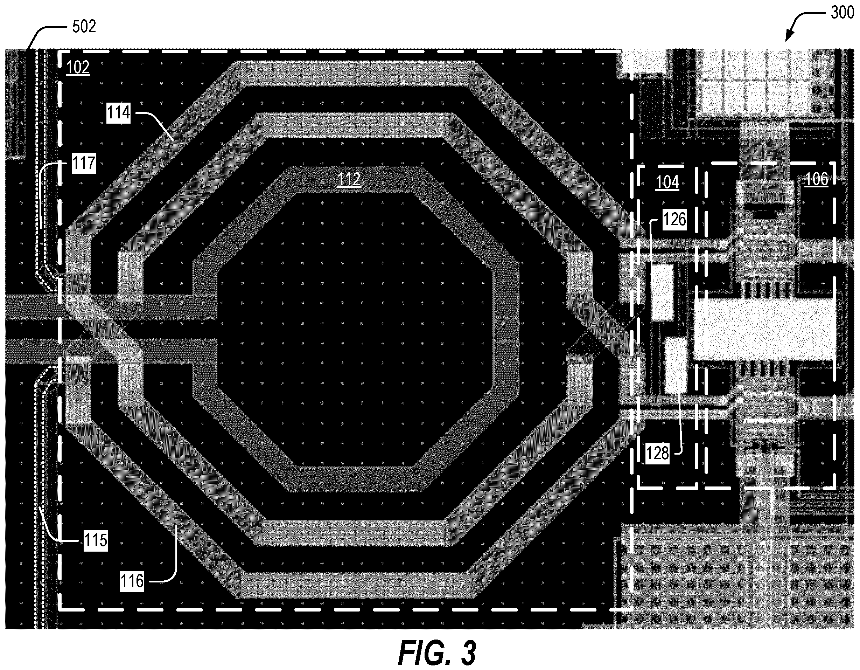

FIG. 3 depicts an image of an embodiment of the layout 300 of the circuit 100 of FIG. 1 on a chip, in accordance with certain embodiments. In the illustrated example, the layout 300 represents the circuit 100 arranged on a test chip 302. The chip 302 includes the primary inductor 112 and secondary inductors 114 and 116. Center taps 115 and 117 are coupled to the secondary inductors 114 and 116, respectively. The chip 302 may include the cancellation network 104 including the capacitors 126 and 128. The chip 302 may include the doubler core 106 including the output transistors 130, 136, 140, and 144 and the output transformer including the inductors 110 and 108.

The secondary inductors 114 and 116 and the primary inductor 112 may occupy the same area as a conventional transformer. In one or more embodiments, the input matching network 102 may occupy a circuit area of approximately 200 micrometers (µm) by 150 µm. The 2 secondary transformers are the same size as a reference design using a conventional transformer topology (the transformer topology used in the reference design and the new transformer topology have the same secondary inductance values). Both capacitors 126 and 128 of the common-mode capacitive cancellation network 104 are well integrated in layout and require less area than the four link capacitors known in the prior art. Therefore, the topology of the circuit 302 does not use any more circuit area than a conventional doubler circuit.

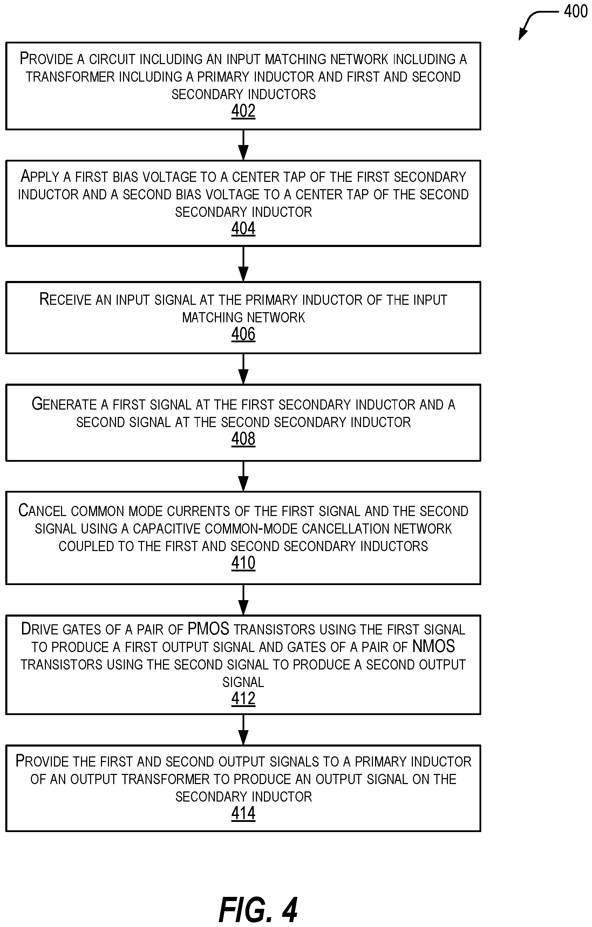

FIG. 4 depicts a flow diagram of a method 400 of providing a frequency-doubled output using the circuit of FIG. 1, in accordance with certain embodiments. The method 400 may be performed using an embodiment of the circuit 100 of FIG. 1.

At 402, the method 400 may include providing a circuit including an input matching network 102 including a transformer including a primary inductor 112 and first and second secondary inductors 114 and 116. In one or more embodiments, the transformer may include a primary inductor 112 and two or more secondary inductors.

At 404, the method 400 may include applying a first bias voltage to a center tap 115 of the first secondary inductor 114 and a second bias voltage to a center tap 117 of the second secondary inductor 116. The first bias voltage may be selected to bias the gates of transistors 130 and 136, and the second bias voltage may be selected to bias the gates of transistors 140 and 144.

At 406, the method 400 may include receiving an input signal at the primary inductor 112 of the input matching network 102. The input signal may be applied to the input terminals of the primary inductor 112.

At 408, the method 400 may include generating a first signal at the first secondary inductor 114 and a second signal at the second secondary inductor 116. The first and second signals may be generated automatically based on the inductive coupling between the primary inductor 112 and the secondary inductors 114 and 116.

At 410, the method 400 may include cancelling common-mode currents of the first signal and the second signal using a capacitive common-mode cancellation network 104 coupled to the first and second secondary inductors 114 and 116. The cancellation network 104 may include a first capacitor 126 coupled between a first terminal of the first secondary inductor 114 and a first terminal of the second secondary inductor 116. The cancellation network 104 may include a second capacitor 128 coupled between a second terminal of the first secondary inductor 114 and a second terminal of the second secondary inductor 116.

At 412, the method 400 may include driving gates of a pair of PMOS transistors 130 and 136 using the first signal to produce a first output signal and gates of a pair of NMOS transistors 140 and 144 using the second signal to produce a second output signal. The transistors 130 and 136 may include a common source coupled to a first power supply terminal and a common drain. The transistors 140 and 144 may include a common drain and a common source coupled to a second power supply terminal, such as ground.

At 414, the method 400 may include providing the first and second output signals to a primary inductor 110 of an output transformer to produce an output signal on the secondary inductor 108. In one or more embodiments, the primary inductor 110 may include a first terminal coupled to the common drain of the PMOS transistors 130 and 136 and may include a second terminal coupled to the common drain of the NMOS transistors 140 and 144.

In conjunction with the circuits and methods described above with respect to FIGs. 1-6, a push-pull frequency doubler circuit is disclosed that includes a transformer-based matching network 102 including a transformer having a primary inductor 112 and two or more secondary inductors, such as the inductors 114 and 116. The secondary inductors may include center taps, such as the center tap 115 of the inductor 114 and the center tap 117 of the inductor 116. The push-pull frequency doubler circuit 100 may include a cancellation network including a first capacitor coupled between a first terminal of the inductor 114 and a first terminal of the inductor 116 and a second capacitor coupled between a second terminal of the inductor 114 and a second terminal of the inductor 116. The push-pull frequency doubler circuit 100 may include a doubler core 106 including a PMOS transistor pair 130 and 136 having a common source coupled to a first supply terminal, a common drain coupled to a first terminal of a primary inductor of an output transformer, and gates. The gate of the PMOS transistor 130 may be coupled to the first terminal of the inductor 114 and the gate of the PMOS transistor 136 may be coupled to the second terminal of the inductor 114. The doubler core 106 may include an NMOS transistor pair 140 and 144 having a common source coupled to a second supply terminal (such as Vss or ground), a common drain coupled to a second terminal of the primary inductor of an output transformer, and gates. The gate of the NMOS transistor 140 may be coupled to the first terminal of the inductor 116 and the gate of the NMOS transistor 144 may be coupled to the second terminal of the inductor 116. A first bias voltage may be applied to the center tap 115 to bias the PMOS transistors 130 and 136, and a second bias voltage may be applied to the center tap 117 to bias the NMOS transistors 140 and 144.

In one or more embodiments, the windings of the secondary inductors 114 and 116 of the input matching network 102 may transfer an input signal from the primary inductor 112 to the two secondary inductors 114 and 116 with low losses. The center taps 115 and 117 allow for applying bias voltages to the gates of the PMOS transistors 130 and 136 and the NMOS transistors 140 and 144 without degrading the noise performance of the circuit 100. In one or more embodiments, the capacitors 126 and 128 of the cancellation network 104 may provide a well-controlled current path for common-mode currents to overcome a capacitive effect of the gate-to-drain capacitances of the transistors 130, 136, 140, and 144. In one or more embodiments, the circuit 100 may reduce the DC power consumption of previous driver stages by as much as sixty percent while reducing the AC voltage drop in the matching network by two decibels and improving the low-frequency (2MHz) phase noise by five decibels relative to convention frequency doubler circuits in the same circuit area as conventional frequency doubler circuits.

Embodiments of the circuit and methods described above may be further understood in view of the Examples presented below.

Example 1: A circuit may include an output transformer including a primary output inductor inductively coupled to a secondary output inductor, the primary output inductor including a first terminal and a second terminal; a doubler core including a first transistor pair and a second transistor pair, the first transistor pair coupled between a first power supply terminal and the first terminal of the primary output inductor, the first transistor pair including a first gate and a second gate, the second transistor pair coupled between a second power supply terminal and the second terminal of the primary output inductor, the second transistor pair including a third gate and a fourth gate; an input matching network may include an input transformer including a primary inductor configured to receive an input signal having a first frequency; a first secondary inductor inductively coupled to the primary inductor and including a third terminal coupled to the first gate, a fourth terminal coupled to the second gate, and a first center tap configured to receive a first bias voltage to bias the first and second gates of the first transistor pair; and a second secondary inductor inductively coupled to the primary inductors and including a fifth terminal coupled to the third gate, a sixth terminal coupled to the fourth gate, and a second center tap configured to receive a second bias voltage to bias the third and fourth gates of the second transistor pair.

Example 2: The circuit of Example 1, further including a cancellation network coupled to the input matching network, the cancellation network including: a first capacitor including a first capacitor terminal coupled to the third terminal of the first secondary inductor and including a second capacitor terminal coupled to the fifth terminal of the second secondary inductor; and a second capacitor including a third capacitor terminal coupled to the fourth terminal of the first secondary inductor and including a second capacitor terminal coupled to the sixth terminal of the second secondary inductor.

Example 3: The circuit of Example 2, where the cancellation network cancels a common-mode loop current, reducing sensitivity of output signals to impedances of the first and second center taps.

Example 4: The circuit of any of Examples 2 or 3, where the first and second capacitors of the cancellation network provide a current path to overcome a capacitive effect of gate-to-drain capacitances of the first and second transistor pairs.

Example 5: The circuit of any of Examples 1-4, where the first bias voltage biases the gates of the first transistor pair and the second bias voltage biases the gates of the second transistor pair.

Example 6: The circuit of any of Examples 1-5, where a second frequency of an output signal at the secondary output inductor is approximately twice the first frequency.

Example 7: The circuit of any of Examples 1-6, where the first transistor pair includes a first transistor including a source coupled to the first supply voltage terminal, a gate coupled to the first terminal of the first secondary inductor, and a drain coupled to the first terminal of the primary output inductor; and a second transistor including a source coupled to the first supply voltage terminal, a gate coupled to the second terminal of the first secondary inductor, and a drain coupled to the first terminal of the primary output inductor; and where the second transistor pair includes a third transistor including a source coupled to the second supply voltage terminal, a gate coupled to the first terminal of the second secondary inductor, and a drain coupled to the second terminal of the primary output inductor; and a fourth transistor including a source coupled to the second supply voltage terminal, a gate coupled to the second terminal of the second secondary inductor, and a drain coupled to the second terminal of the primary output inductor.

Example 8: The circuit of any of Examples 1-7, where the input matching network further includes one or more third secondary inductors.

Example 9: A method of doubling a frequency of an input includes applying a first bias voltage to a first center tap of a first secondary inductor of an input transformer of an input matching network, the input transformer further including a primary inductor and a second secondary inductor; applying a second bias voltage to a second center tap of the second secondary inductor; receiving an input signal having a first frequency at the primary inductor; producing a first signal related to the input signal at first and second terminals of the first secondary inductor and a second signal related to the input signal at third and fourth terminals of the second secondary inductor; biasing first gates of a first transistor pair of a doubler core circuit with the first bias voltage to produce a first doubler signal and second gates of a second transistor pair of the doubler core circuit with the second bias voltage to produce a second doubler signal; applying the first doubler signal to a first terminal of a primary output inductor of an output transformer having a secondary output inductor; and applying the second doubler signal to a second terminal of the primary output inductor to provide an output signal at the secondary output inductor having a second frequency that is twice the first frequency.

Example 10: The method of Example 9, further including canceling a common-mode loop current using a cancellation network coupled to the first and second secondary inductors, where the cancellation network includes: a first capacitor coupled between the first terminal of the first secondary inductor and the third terminal of the second secondary inductor; and a second capacitor coupled between the second terminal of the first secondary inductor and the fourth terminal of the second secondary inductor.

Example 11: The method of Example 9, further including adjusting one or more of the first bias voltage at the first center tap or the second bias voltage at the second center tap to adjust the biasing of one or more of the first gates or the second gates.

Example 12: A circuit includes an input matching network, a cancellation network, and a doubler core, the input matching network including an input transformer including: a primary inductor configured to receive an input signal having a first frequency; a first secondary inductor including a first terminal, a second terminal, and a first center tap, the first center tap configured to receive a first bias voltage; and a second secondary inductor including a first terminal, a second terminal, and a second center tap, the second center tap configured to receive a second bias voltage; the cancellation network coupled to the input matching network, the cancellation network including: a first capacitor including a first terminal coupled to the first terminal of the first secondary inductor and including a second terminal coupled to the first terminal of the second secondary inductor; and a second capacitor including a first terminal coupled to the second terminal of the first secondary inductor and including a second terminal coupled to the second terminal of the second secondary inductor; an output transformer coupled to the input matching network and the cancellation network, the output transformer including a primary output inductor including a first output terminal and a second output terminal; and a secondary output inductor inductively coupled to the primary output inductor; and the doubler core coupled to the cancellation network and to the output transformer, the doubler core including : a first transistor pair including first terminals coupled to a first power supply terminal, second terminals coupled to the first terminal of the primary output inductor, and gates coupled to the first and second terminals of the first secondary inductor; and a second transistor pair including first terminals coupled to the second terminal of the primary output inductor, second terminals coupled to a second power supply terminal, and gates coupled to the first and second terminals of the second secondary inductor.

Example 13: The circuit of Example 12, where the first bias voltage biases the gates of the first transistor pair and the second bias voltage biases the gates of the second transistor pair.

Example 14: The circuit of any of Examples 12 or 13, where one or more of the first bias voltage and the second bias voltage is adjustable.

Example 15: The circuit of any of Examples 12-14, where a second frequency of an output signals at the secondary output inductor is approximately twice the first frequency.

Example 16: The circuit of Example 15, where the cancellation network cancels a common-mode loop current, reducing sensitivity of the output signals to impedances of the first and second center taps.

Example 17: The circuit of any of Examples 12-16, where the first transistor pair includes: a first transistor including a source coupled to the first supply voltage terminal, a gate coupled to the first terminal of the first secondary inductor, and a drain coupled to the first terminal of the primary output inductor; and a second transistor including a source coupled to the first supply voltage terminal, a gate coupled to the second terminal of the first secondary inductor, and a drain coupled to the first terminal of the primary output inductor; and where the second transistor pair includes: a third transistor including a source coupled to the second supply voltage terminal, a gate coupled to the first terminal of the second secondary inductor, and a drain coupled to the second terminal of the primary output inductor; and a fourth transistor including a source coupled to the second supply voltage terminal, a gate coupled to the second terminal of the second secondary inductor, and a drain coupled to the second terminal of the primary output inductor.

Example 18: The circuit of any of Examples 12-17, where the input matching network further comprises one or more third secondary inductors.

Example 19: The circuit of any of Examples 12-18, where the first and second capacitors of the cancellation network provide a current path to overcome a capacitive effect of gate-to-drain capacitances of the first and second transistor pairs.

Example 20: The circuit of any of Examples 12-19, where the first bias voltage is different from the second bias voltage.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

## Claims

1. A circuit comprising:
an output transformer including a primary output inductor inductively coupled to a secondary output inductor, the primary output inductor including a first terminal and a second terminal;
a doubler core including a first transistor pair and a second transistor pair, the first transistor pair coupled between a first power supply terminal and a first terminal of the primary output inductor, the first transistor pair including a first gate and a second gate, the second transistor pair coupled between a second power supply terminal and the second terminal of the primary output inductor, the second transistor pair including a third gate and a fourth gate;
an input matching network comprising an input transformer comprising:
a primary inductor configured to receive an input signal having a first frequency;
a first secondary inductor inductively coupled to the primary inductor and including a third terminal coupled to the first gate, a fourth terminal coupled to the second gate, and a first center tap configured to receive a first bias voltage to bias the first and second gates of the first transistor pair; and
a second secondary inductor inductively coupled to the primary inductor and including a fifth terminal coupled to the third gate, a sixth terminal coupled to the fourth gate, and a second center tap configured to receive a second bias voltage to bias the third and fourth gates of the second transistor pair.

2. The circuit of claim 1, further comprising:
a cancellation network coupled to the input matching network, the cancellation network comprising:
a first capacitor including a first capacitor terminal coupled to the third terminal of the first secondary inductor and including a second capacitor terminal coupled to the fifth terminal of the second secondary inductor; and
a second capacitor including a third capacitor terminal coupled to the fourth terminal of the first secondary inductor and including a fourth capacitor terminal coupled to the sixth terminal of the second secondary inductor.

3. The circuit of claim 2, wherein the cancellation network cancels a common-mode loop current, reducing sensitivity of output signals to impedances of the first and second center taps.

4. The circuit of claim 2 or 3, wherein the first and second capacitors of the cancellation network provide a current path to overcome a capacitive effect of gate-to-drain capacitances of the first and second transistor pairs.

5. The circuit of any preceding claim, wherein the first bias voltage biases the gates of the first transistor pair and the second bias voltage biases the gates of the second transistor pair.

6. The circuit of any preceding claim, wherein a second frequency of an output signal at the secondary output inductor is approximately twice the first frequency.

7. The circuit of any preceding claim, wherein the first transistor pair comprises:
a first transistor including a source coupled to the first supply voltage terminal, the first gate coupled to the third terminal of the first secondary inductor, and a drain coupled to the first terminal of the primary output inductor; and
a second transistor including a source coupled to the first supply voltage terminal, the second gate coupled to the fourth terminal of the first secondary inductor, and a drain coupled to the first terminal of the primary output inductor; and
wherein the second transistor pair comprises:
a third transistor including a source coupled to the second supply voltage terminal, the third gate coupled to the fifth terminal of the second secondary inductor, and a drain coupled to the second terminal of the primary output inductor; and
a fourth transistor including a source coupled to the second supply voltage terminal, the fourth gate coupled to the sixth terminal of the second secondary inductor, and a drain coupled to the second terminal of the primary output inductor.

8. The circuit of any preceding claim, wherein the input matching network further comprises one or more third secondary inductors.

9. A method of doubling a frequency of an input signal, the method comprising:
applying a first bias voltage to a first center tap of a first secondary inductor of an input transformer of an input matching network, the input transformer further including a primary inductor inductively coupled to a second secondary inductor;
applying a second bias voltage to a second center tap of the second secondary inductor;
receiving an input signal having a first frequency at the primary inductor;
producing a first signal related to the input signal at first and second terminals of the first secondary inductor and a second signal related to the input signal at third and fourth terminals of the second secondary inductor;
biasing first gates of a first transistor pair of a doubler core circuit with the first bias voltage to produce a first doubler signal and second gates of a second transistor pair of the doubler core circuit with the second bias voltage to produce a second doubler signal;
applying the first doubler signal to a first terminal of a primary output inductor of an output transformer having a secondary output inductor that is inductively coupled to the primary output inductor; and
applying the second doubler signal to a second terminal of the primary output inductor to provide an output signal at the secondary output inductor having a second frequency that is twice the first frequency.

10. The method of claim 9, further comprising:
canceling a common-mode loop current using a cancellation network coupled to the first and second secondary inductors, wherein the cancellation network comprises:
a first capacitor coupled between the first terminal of the first secondary inductor and the third terminal of the second secondary inductor; and
a second capacitor coupled between the second terminal of the first secondary inductor and the fourth terminal of the second secondary inductor.

11. The method of claim 9 or 10, further comprising adjusting one or more of the first bias voltage at the first center tap or the second bias voltage at the second center tap to adjust the biasing of one or more of the first gates or the second gates.
